# EUROPEAN PATENT APPLICATION

(11) **EP 4 839 076 A1**
(43) Date of publication of application: **11.11.2026**
(21) Application number: 26174771.1
(22) Date of filing: 27.04.2026
(51) Int. Cl.: H10W 40/60, H10W 40/00, H10W 40/20, H10W 40/22

(54) **POWER MODULE MOUNTING ARRANGEMENT**

(30) Priority: 06.05.2025 US 202563800832 P; 27.06.2025 US 202519252274
(71) Applicant: Infineon Technologies AG, 85579 Neubiberg (DE)
(72) Inventor: KOCH, Michael, 59597 Erwitte (DE); DITZ, Michael, 59939 Olsberg (DE)
(74) Representative: Westphal, Mussgnug & Partner, Patentanwälte mbB

(57) **Abstract**

A power module assembly includes a base plate, a substrate, and a housing. The base plate includes at least two openings extending vertically therethrough. The substrate is fixed to an upper surface of the base plate. The housing includes at least two housing protrusions extending downwardly from a lower surface of the housing in a direction of the base plate. Each of the at least two housing protrusions has an outer linear dimension, and an inner linear dimension defined by an upwardly extending aperture. The lower surface of the housing is positioned on the upper surface of the base plate such that each of the at least two housing protrusions is positioned within one of the at least two openings in the base plate.

## Description

This application is a Continuation Application of U.S. Provisional Application No. 63/800,832, filed May 6, 2025, which is incorporated by reference herein in its entirety.

### TECHNICAL FIELD

The instant disclosure relates to an arrangement for aligning and mounting a power module to a mounting surface such as a heat sink.

### BACKGROUND

The automation of assembly processes to optimize costs is an important step in the manufacture of semiconductor power modules. This results in higher demands on the dimensional accuracy of the modules as well as external components such as heat sinks and PCBs. For example, it must be ensured that the PCB can be securely joined to the contact pins of the power module.

In typical base plate modules, contact pins are positioned on the module substrate and the module housing is screwed to the base plate. The modules are subsequently mounted to a mounting surface such as a heat sink. This results in several reference levels from the base plate to the substrates, the module housing, the heat sink, and the contact pins. Existing arrangements for positioning the frame on the base plate and the base plate on the heat sink do not fulfil the high positioning requirements that are necessary for simple, automated assembly. In addition, this can lead to increased yield loss in current production, as the requirements for the pin positions cannot entirely be met.

### SUMMARY

According to an embodiment of a power module assembly, the power module assembly comprises: a base plate comprising at least two openings extending vertically therethrough; a substrate fixed to an upper surface of the base plate; and a housing comprising at least two housing protrusions extending downwardly from a lower surface of the housing in a direction of the base plate, wherein each of the at least two housing protrusions has an outer linear dimension, and an inner linear dimension defined by an upwardly extending aperture, wherein the lower surface of the housing is positioned on the upper surface of the base plate such that each of the at least two housing protrusions is positioned within one of the at least two openings in the base plate.

According to an embodiment of a method for assembling a power module assembly, the method comprises: providing a base plate comprising at least two openings extending vertically therethrough; mounting a substrate to an upper surface of the base plate; providing a housing comprising at least two housing protrusions extending downwardly from a lower surface of the housing, wherein each of the at least two housing protrusions has an outer linear dimension, and an inner linear dimension defined by an upwardly extending aperture; and positioning the lower surface of the housing on the upper surface of the base plate such that each of the at least two housing protrusions is positioned within one of the at least two openings in the base plate.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
FIG. 1 illustrates a three-dimensional view of a power module assembly in an unassembled state, including a power module and externally connected components.
FIG. 2A illustrates a three-dimensional view of a power module in an unassembled state, including a base plate and a module housing having housing protrusions that are configured as alignment features according to an embodiment of the disclosure.
FIG. 2B illustrates a three-dimensional view of a power module in an assembled state, including a base plate and a module housing aligned using alignment features according to an embodiment of the disclosure.
FIG. 3 illustrates a partial cross-sectional view of a power module assembly in an assembled state, including a power module mounted to a heat sink using an alignment feature according to an embodiment of the disclosure.

### DETAILED DESCRIPTION

Disclosed herein is an arrangement for accurately aligning a power module housing with a base plate and an external mounting surface such as a heat sink. The housing includes alignment features that are implemented as housing protrusions extending from a lower surface of the housing. Each housing protrusion includes an aperture extending upwardly therein. Assembly of the power module includes aligning the housing with the base plate by inserting each housing protrusion into a corresponding opening in the base plate. Assembly of the power module with an external mounting surface such as a heat sink may include aligning the power module with the external mounting surface by inserting alignment features of the external mounting surface into the apertures of the housing. The housing protrusions disclosed herein thus provide a universal alignment reference point for assembling components of the power module and assembling the power module with external components. Utilizing a housing with such protrusions when assembling a power module and/or power module assembly as disclosed herein may therefore improve alignment of the constituent components with one another during the assembly process, potentially simplifying manufacturing, enabling automated manufacturing processes, and even improving mechanical robustness of the power module and/or power module assembly.

Described next, with reference to the figures, are exemplary embodiments of the power module assembly.

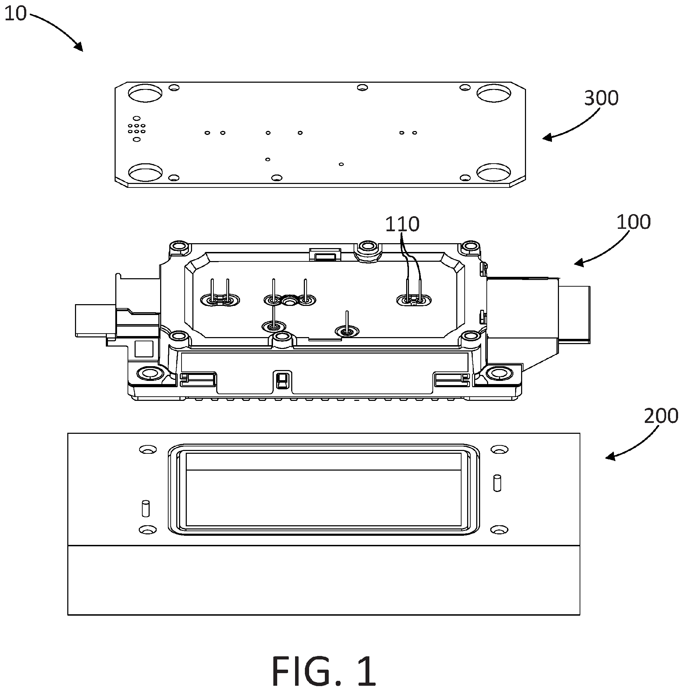

FIG. 1 illustrates a three-dimensional view of a power module assembly 10 in an unassembled state, including a power module 100 and externally connected components. In this example, the externally connected components include a heat sink 200 and a PCB (printed circuit board) 300. The power module 100 has contacts such as pins 110 extending above the power module 100 for contact with customer circuitry, such as might be incorporated into the PCB 300. The power module 100 is further configured to be mounted to a mounting surface such as the heat sink 200, which may be necessary both to provide a secure mounting surface for the power module 100 and to ensure adequate cooling of the power module 100 during operation.

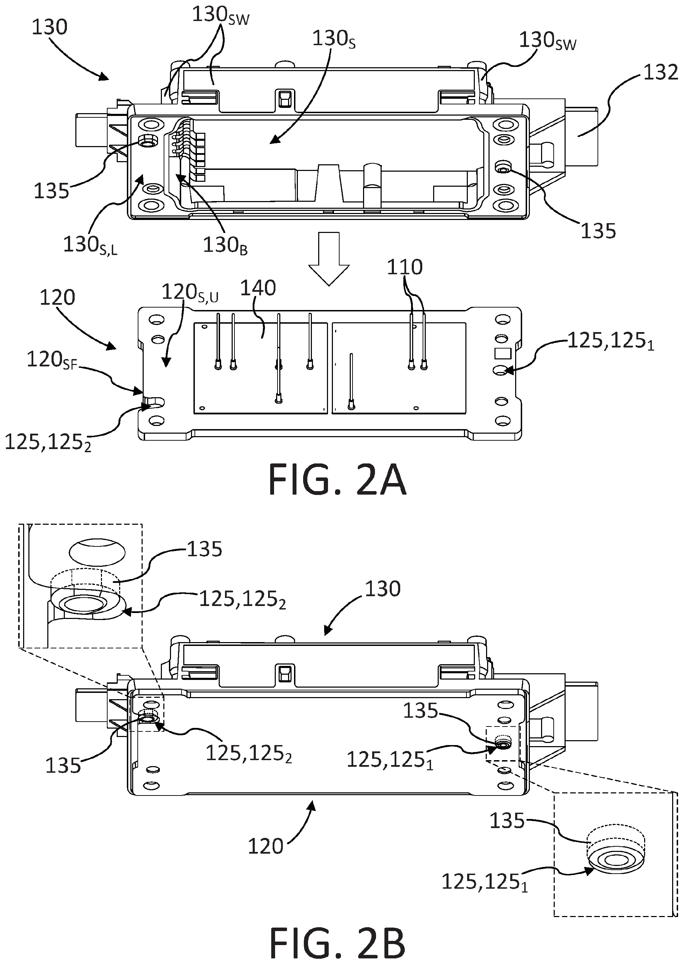

FIG. 2A illustrates a three-dimensional view of the power module 100 in an unassembled state, including a base plate 120 and a module housing 130 having housing protrusions 135 that are configured as alignment features according to an embodiment of the disclosure. FIG. 2B illustrates a three-dimensional view of the power module 100 in an assembled state, including the base plate 125 and the module housing 130 aligned using alignment features according to an embodiment of the disclosure.

The base plate 120 may be formed from a metal, ceramic, or any other suitable material. The base plate 120 may, for example, be formed from a relatively high thermal conductivity metal such as copper or aluminum. The base plate 120 includes at least two openings 125 extending vertically therethrough for reasons that will be explained below.

A substrate 140, to which semiconductor chips, conductors such as the pins 110, and other components are mounted, is mounted and fixed to an upper surface 120_{S,U} of the rigid base plate 120 using soldering, sintering, or another suitable technology. Examples of the substrate 140 include a DCB (direct copper bonded) or AMB (active metal brazed) substrate, printed circuit board (PCB), lead frame, or other substrate, e.g., insulated metal substrate (IMS), etc. The substrate 140 may include one or more insulating layers and/or metallization layers. An insulating layer may include a ceramic, a polymer such as polyimide, etc. A metallization layer may include copper, aluminum, an alloy, etc., and may include one or more traces and/or contact pads. Semiconductor chips, active components, passive components, terminals, the pins 110, etc. may be attached a metallization layer of the substrate 140.

The housing 130 of this example is a frame-type housing. The housing 130 includes sidewalls 130_{SW} that form an enclosure having an open interior space 130_{S} for enclosing the module electronics. The housing 130 may optionally include a separate or integrally formed cover as well (not illustrated). The housing 130 may also serve to support and position various conductors and terminals 132. The housing 130 may include one or more pieces of metal, plastic, composite, and/or other suitable material. In some examples, the housing 130 is a molded housing that is formed from a mold compound. A mold compound is a plastic encapsulant typically formed from an organic resin such as an epoxy resin. The plastic encapsulant may include fillers such as non-melting inorganic materials. Catalysts may be used to accelerate the cure reaction of the organic resin. Other materials such as flame retardants, adhesion promoters, ion traps, stress relievers, colorants, etc. may be added to the plastic encapsulant, as appropriate. The mold compound may be formed by injection molding, compression molding, film-assisted molding (FAM), reaction injection molding (RIM), resin transfer molding (RTM), blow molding, etc.

According to an embodiment, the housing 130 includes at least two housing protrusions 135. The housing protrusions 135 each extend downwardly from a lower surface 130_{S,L} of the housing 130. One or more of the housing protrusions 135 may be formed integrally with a body 130_{B} of the housing 130 (e.g., during a molding process). Alternatively, one or more of the housing protrusions 135 may be a separate piece that is attached to the housing 130.

The power module 100 is assembled by securely mounting the housing 130 to the base plate 120. The housing 130 and the base plate 120 are aligned using the housing protrusions 135 and the openings 125 in the base plate 120 as alignment features. As the housing 130 is lowered onto the base plate 120, the housing protrusions 135 are inserted into the openings 125 so that the housing 130 and the base plate 120 are fully aligned. More specifically, the lower surface 130_{S,L} of the housing 130 is positioned on the upper surface 120_{S,U} of the base plate 120 such that each of the housing protrusions 135 is positioned within one of the openings 125 in the base plate 120. The alignment tolerance of the housing 130 with the base plate 120 is therefore determined by outer linear dimensions of the housing protrusions 135 and inner linear dimensions of the openings 125. After this alignment, the housing 130 and the base plate 120 may be securely connected to one another by conventional methods. For example, mechanical fasteners such as bolts or rivets could be used. Other securing methods, such as adhesives or welding, could also be used. The result is a fully assembled and operational power module 100, ready to be assembled by an end user to additional circuitry such as the PCB 300, power connections via the terminals 132, and/or a mounting surface such as the heat sink 200.

The openings 125 and the housing protrusions 135 may take any suitable shape as long as they prevent lateral movement of the housing 130 relative to the base plate 120 when the protrusions 135 are seated therein. In the example of FIGS. 2A and 2B, a first opening 125₁ shown at the right of FIGS. 2A and 2B has a circular shape and a second opening 125₂ at the left has an oblong shape, although other combinations of shapes are contemplated. Additionally, the openings 125 may take the form of closed holes, such as that of the first opening 125₁, or slotted as shown with the second opening 125₂. In this example, the second opening 125₂ is a slot formed in a side face 120_{SF} of the base plate 120. A slotted opening may ease initial placement of the housing 130 by allowing a first housing protrusion 135 to simply slide in and be positioned laterally within a respective opening 125 before vertically inserting a second housing protrusion 135 into a different opening 125. While two housing protrusions 135 and two openings 125 are shown here, additional housing protrusions 135 and openings 125 may also be provided. The housing protrusions 135 are hollow for reasons that will be explained below.

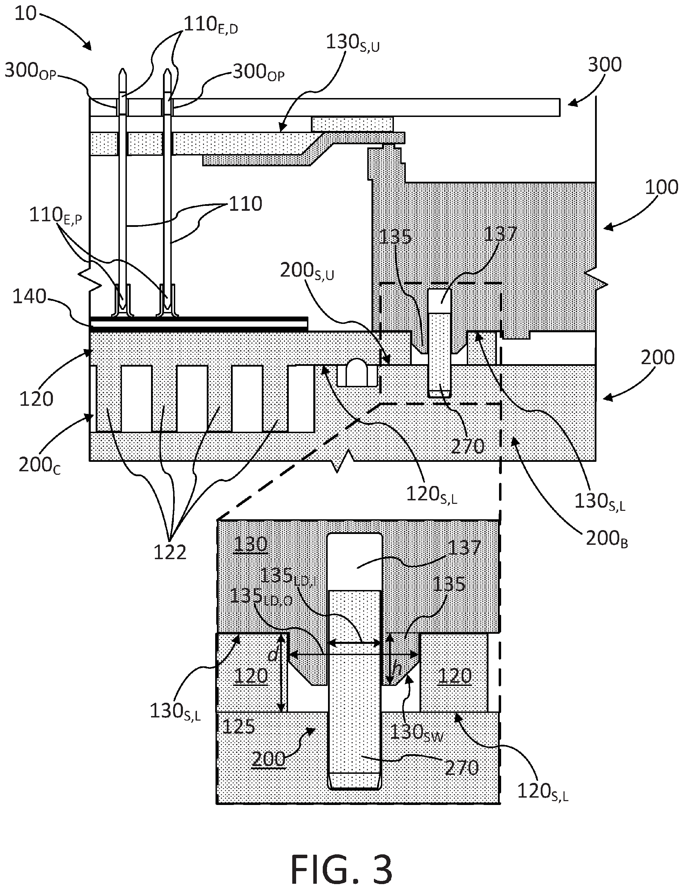

FIG. 3 illustrates a partial cross-sectional view of the power module assembly 10 in an assembled state, including the power module 100 mounted to the heat sink 200 using an alignment feature (a housing protrusion 135) according to an embodiment of the disclosure. Specifically, FIG. 3 illustrates a partial view of the power module 100 securely aligned and mounted to the PCB 300 and to the heat sink 200.

The heat sink 200 includes at least two alignment features 270 extending upwardly from an upper surface 200_{S,U} of the heat sink, one of which is illustrated in the partial view of FIG. 3. Each alignment feature 270 may, for example, be a pin or a dowel. Alternatively, the alignment features 270 may be projections integrally formed from and of the same material as the heat sink 200. The alignment features 270 are securely fixed to the heat sink 200. For example, the alignment features 270 illustrated in FIG. 3 is a separate member that is inserted into an opening 200_{OP} formed in the upper surface 200_{S,U} of the heat sink 200 and extends downwardly into a body 200_{B} of the heat sink 200. Alternatively, one or more of the alignment features 270 may be formed integrally with the heat sink 200.

Each of the at least two housing protrusions 135 extends downwardly from the lower surface 130_{S,L} of the housing 130 in a direction of the base plate 120 such that each housing protrusion 135 has a height h measured from the lower surface 130_{S,L} of the housing 130. As noted above, the housing protrusions 135 are hollow. More specifically, each of the housing protrusions 135 has an outer linear dimension 135_{LD,O} and an inner linear dimension 135_{LD,I}. The inner linear dimension 135_{LD,I} is defined by an upwardly extending aperture 137. In some examples, at least one of the housing protrusions 135 is round such that the outer linear dimension 135_{LD,O} is an outer diameter and the inner linear dimension 135_{LD,I} is an inner diameter defined by the aperture 137. In one example, at least one of the housing protrusions 135 has one or more tapered sidewalls 135_{SW} such that the outer linear dimension 135_{LD,O} decreases with increasing distance from the lower surface 130_{S,L} of the housing 130.

As the power module 100 is lowered onto the heat sink 200, the alignment features 270 of the heat sink 200 are inserted into the apertures 137 of the housing protrusions 135. Specifically, the lower surface 120_{S,L} of the base plate 120 is positioned on the upper surface 200_{S,U} of heat sink 200 such that each of the alignment features 270 is received by the aperture 137 in one of the housing protrusions 135, ensuring that power module 100 and heat sink 200 are perfectly aligned upon assembly of the power module 100, with the alignment tolerance of the power module 100 with the heat sink 200 determined by the inner linear dimensions 135_{LD,I} of the housing protrusions 135 (i.e., the linear dimensions of the apertures 137) and outer linear dimensions of the alignment features 270. The apertures 137 of the housing protrusions 135 may be sized to perfectly mate with the alignment features 270, or they might be designed slightly larger to ease assembly depending upon design tolerances. In some examples, the height h of a respective housing protrusion 135 is less than a depth d of the opening 125 of the base plate 120 within which the respective housing protrusion 135 is received, such that the respective housing protrusion 135 is recessed from the lower surface 120_{S,L} of the base plate 120. After the power module 100 is fully seated and aligned with the heat sink 200, the power module 100 and the heat sink 200 may be attached to one another by any suitable method such as mechanical fasteners, adhesive, or welding.

In the example of FIG. 3, the base plate 120 includes a plurality of elongated features 122 extending downwardly from a lower surface 120_{S,L} of the baseplate 120. The heat sink 200 includes a cavity 200_{C} formed in the upper surface 200_{S,U} of the heat sink 200. When the lower surface 120_{S,L} of the base plate 120 is positioned on the upper surface 200_{S,U} of heat sink 200, the elongated features 122 of the base plate 120 are received by the cavity 200_{C} of the heat sink 200. During operation of the power semiconductor assembly 10, a cooling fluid may be passed through the portion of the cavity 200_{C} that is not occupied by the elongated features 122 of the base plate 120, potentially enhancing dissipation of heat from the power module 100.

The housing protrusions 135 and the base plate openings 125 represent cost-neutral design elements, which not only ensure precise alignment of the housing 130 and the base plate 120, making the module assembly process more robust and reducing yield loss, but also serve to center the power module 100 on the heat sink 200. More specifically, the alignment tolerance of the housing 130 with the base plate 120 is determined by the outer linear dimensions 135_{LD,O} of the housing protrusions 135, while the alignment tolerance of the power module 100 with the heat sink 200 is determined by the inner linear dimensions 135_{LD,I}. Thanks to this continuous reference plane, module tolerances can be significantly reduced and simple, automated module assembly of the full power module assembly 10 can be guaranteed. This permanent alignment also increases resistance to high mechanical vibration loads and thus minimizes the risk of delamination of the welded terminals (e.g., the pins 110) on the substrate 140.

The power module 100 may be mounted to the PCB 300 by the plurality of pins 110. In the example of FIG. 3, a proximal end 110_{E,P} of each pin 110 is attached to the substrate 140 (e.g., a metallization layer of the substrate 140). The proximal ends 110_{E,P} of the pins 110 may be attached directly to the substrate 140, e.g., by welding (laser welding), soldering, adhering, etc., or may be attached to the substrate 140 by intervening features such as sleeves or rivets (not illustrated). It is also contemplated that the pins 110 could be attached directly or indirectly to upper surfaces of the chips instead of or in addition to the substrate 140. The pins 110 extend upwardly beyond an upper surface 130_{S,U} of the housing 130, and a distal end 110_{E,D} of each of the pins 110 is inserted into a respective opening 300_{OP} in the printed circuit board 300 to secure and electrically couple the power module 100 and the PCB 300 to one another. The distal end 110_{E,D} of a respective pin 110 may be a press-fit end that is configured to plastically and/or elastically deform when pressed against the walls of an opening 300_{OP}, thus securing the pin 110 to the PCB 300. Alternatively, the distal end 110_{E,D} of a respective pin 110 may be configured to be inserted into an opening 300_{OP} and soldered or otherwise secured to the PCB 300.

Although the present disclosure is not so limited, the following numbered examples demonstrate one or more aspects of the disclosure.

Example 1. A power module assembly comprising: a base plate comprising at least two openings extending vertically therethrough; a substrate fixed to an upper surface of the base plate; and a housing comprising at least two housing protrusions extending downwardly from a lower surface of the housing in a direction of the base plate, wherein each of the at least two housing protrusions has an outer linear dimension, and an inner linear dimension defined by an upwardly extending aperture, wherein the lower surface of the housing is positioned on the upper surface of the base plate such that each of the at least two housing protrusions is positioned within one of the at least two openings in the base plate.

Example 2. The power module assembly of example 1, further comprising: a heat sink with at least two alignment features extending upwardly from an upper surface of the heat sink, wherein a lower surface of the base plate is positioned on the upper surface of heat sink such that each of the at least two alignment features is received by the aperture in one of the at least two housing protrusions.

Example 3. The power module assembly of example 2, wherein at least one of the at least two alignment features is formed integrally with the heat sink.

Example 4. The power module assembly of example 2 or 3, wherein at least one of the at least two alignment features is inserted into an opening formed in the upper surface of the heat sink and extends downwardly into a body of the heat sink.

Example 5. The power module assembly of any of examples 2 through 4, wherein each of the at least two alignment features is a pin or a dowel.

Example 6. The power module assembly of any of examples 1 through 5, wherein at least one of the at least two housing protrusions is round such that the outer linear dimension is an outer diameter and the inner linear dimension is an inner diameter defined by the aperture.

Example 7. The power module assembly of any of examples 1 through 6, wherein at least one of the at least two housing protrusions has one or more tapered sidewalls such that the outer linear dimension decreases with increasing distance from the lower surface of the housing.

Example 8. The power module assembly of any of examples 1 through 7, wherein at least one of the at least two housing protrusions has a height measured from the lower surface of the housing that is less than a depth of the opening of the base plate within which the housing protrusion is received.

Example 9. The power module assembly of any of examples 1 through 8, wherein at least one of the at least two housing protrusions is formed integrally with a body of the housing.

Example 10. The power module assembly of any of examples 1 through 9, further comprising a plurality of pins attached to the substrate and extending upwardly beyond an upper surface of the housing.

Example 11. The power module assembly of example 10, further comprising a printed circuit board, wherein a distal end of each of the pins is inserted into a respective opening in the printed circuit board.

Example 12. The power module assembly of any of examples 1 through 11, wherein a first opening of the at least two openings has a circular shape, and wherein a second opening of the at least two openings has an oblong shape.

Example 13. The power module assembly of example 12, wherein the second opening is a slot formed in a side face of the base plate.

Example 14. The power module assembly of any of examples 1 through 13, wherein the housing is a frame-type housing that forms an enclosure having an open interior space and/or the housing is a molded housing.

Example 15. The power module assembly of any of examples 1 through 14, wherein the base plate comprises a plurality of elongated features extending downwardly from a lower surface of the baseplate.

Example 16. The power module assembly of example 15, further comprising: a heat sink comprising at least two alignment features extending upwardly from an upper surface of the heat sink, and a cavity formed in the upper surface of the heat sink, wherein the lower surface of the base plate is positioned on the upper surface of heat sink such that each of the at least two alignment features is received by the aperture in one of the at least two housing protrusions, and such that the elongated features are received by the cavity.

Example 17. A method for assembling a power module assembly, comprising: providing a base plate comprising at least two openings extending vertically therethrough; mounting a substrate to an upper surface of the base plate; providing a housing comprising at least two housing protrusions extending downwardly from a lower surface of the housing, wherein each of the at least two housing protrusions has an outer linear dimension, and an inner linear dimension defined by an upwardly extending aperture; and positioning the lower surface of the housing on the upper surface of the base plate such that each of the at least two housing protrusions is positioned within one of the at least two openings in the base plate.

Example 18. The method of example 17, further comprising: providing a heat sink with at least two alignment features extending upwardly from an upper surface of the heat sink; positioning a lower surface of the base plate on the upper surface of the heat sink such that each of the at least two alignment features is received by the aperture in one of the at least two housing protrusions.

Example 19. The method of example 17 or 18, further comprising attaching a proximal end of each of a plurality of pins to the substrate such that each of the pins extends upwardly beyond an upper surface of the housing.

Example 20. The method of example 19, further comprising inserting a distal end of each pin into an opening in a printed circuit board.

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

The expression "and/or" should be interpreted to include all possible conjunctive and disjunctive combinations, unless expressly noted otherwise. For example, the expression "A and/or B" should be interpreted to mean A but not B, B but not A, or both A and B. The expression "at least one of" should be interpreted in the same manner as "and/or", unless expressly noted otherwise. For example, the expression "at least one of A and B" should be interpreted to mean A but not B, B but not A, or both A and B.

It is to be understood that the features of the various embodiments described herein can be combined with each other, unless specifically noted otherwise.

Although specific embodiments have been illustrated and described herein, it will be appreciated by those of ordinary skill in the art that a variety of alternate and/or equivalent implementations can be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A power module assembly (10) comprising:
a base plate (120) comprising at least two openings (125) extending vertically therethrough;
a substrate (140) fixed to an upper surface (120_{S,U}) of the base plate (120); and
a housing (130) comprising at least two housing protrusions (135) extending downwardly from a lower surface (130_{S,L}) of the housing (130) in a direction of the base plate (120),
wherein each of the at least two housing protrusions (135) has an outer linear dimension (135_{LD,O}), and an inner linear dimension (135_{LD,I}) defined by an upwardly extending aperture (137),
wherein the lower surface (130_{S,L}) of the housing (130) is positioned on the upper surface (120_{S,U}) of the base plate (120) such that each of the at least two housing protrusions (135) is positioned within one of the at least two openings (125) in the base plate (120).

2. The power module assembly (10) of claim 1, further comprising:
a heat sink (200) with at least two alignment features (270) extending upwardly from an upper surface (200_{S,U}) of the heat sink (200),
wherein a lower surface of the base plate (120) is positioned on the upper surface (200_{S,U}) of heat sink (200) such that each of the at least two alignment features (270) is received by the aperture (137) in one of the at least two housing protrusions (135).

3. The power module assembly (10) of claim 2, wherein
at least one of the at least two alignment features (270) is formed integrally with the heat sink (200); or
at least one of the at least two alignment features (270) is inserted into an opening formed in the upper surface (200_{S,U}) of the heat sink (200) and extends downwardly into a body of the heat sink (200).

4. The power module assembly (10) of claim 2, wherein each of the at least two alignment features (270) is a pin or a dowel.

5. The power module assembly (10) of claim 1, wherein at least one of
at least one of the at least two housing protrusions (135) is round such that the outer linear dimension (135_{LD,O}) is an outer diameter and the inner linear dimension (135_{LD,I}) is an inner diameter defined by the aperture (137);
at least one of the at least two housing protrusions (135) has one or more tapered sidewalls (135_{SW}) such that the outer linear dimension (135_{LD,O}) decreases with increasing distance from the lower surface (130_{S,L}) of the housing (130);
at least one of the at least two housing protrusions (135) has a height measured from the lower surface (130_{S,L}) of the housing (130) that is less than a depth of the opening of the base plate (120) within which the housing protrusion (135) is received; and
at least one of the at least two housing protrusions (135) is formed integrally with a body of the housing (130).

6. The power module assembly (10) of claim 1, further comprising a plurality of pins (110) attached to the substrate (140) and extending upwardly beyond an upper surface of the housing (130).

7. The power module assembly (10) of claim 6, further comprising a printed circuit board (300), wherein a distal end (110_{E,D}) of each of the pins (110) is inserted into a respective opening in the printed circuit board (300).

8. The power module assembly (10) of claim 1, wherein a first opening of the at least two openings (125) has a circular shape, and wherein a second opening of the at least two openings (125) has an oblong shape.

9. The power module assembly (10) of claim 8, wherein the second opening is a slot formed in a side face of the base plate (120).

10. The power module assembly (10) of claim 1, wherein the housing (130) is a frame-type housing that forms an enclosure having an open interior space and/or the housing (130) is a molded housing.

11. The power module assembly (10) of claim 1, wherein the base plate (120) comprises a plurality of elongated features extending downwardly from a lower surface of the base plate (120).

12. The power module assembly (10) of claim 11, further comprising:
a heat sink (200) comprising at least two alignment features (270) extending upwardly from an upper surface (200_{S,U}) of the heat sink (200), and a cavity formed in the upper surface (200_{S,U}) of the heat sink (200),
wherein the lower surface of the base plate (120) is positioned on the upper surface (200_{S,U}) of heat sink (200) such that each of the at least two alignment features (270) is received by the aperture (137) in one of the at least two housing protrusions (135), and such that the elongated features are received by the cavity.

13. A method for assembling a power module assembly (10), comprising:
providing a base plate (120) comprising at least two openings (125) extending vertically therethrough;
mounting a substrate (140) to an upper surface (120_{S,U}) of the base plate (120);
providing a housing (130) comprising at least two housing protrusions (135) extending downwardly from a lower surface (130_{S,L}) of the housing (130), wherein each of the at least two housing protrusions (135) has an outer linear dimension (135_{LD,O}), and an inner linear dimension (135_{LD,I}) defined by an upwardly extending aperture (137); and
positioning the lower surface (130_{S,L}) of the housing (130) on the upper surface (120_{S,U}) of the base plate (120) such that each of the at least two housing protrusions (135) is positioned within one of the at least two openings (125) in the base plate (120).

14. The method of claim 13, further comprising:
providing a heat sink (200) with at least two alignment features (270) extending upwardly from an upper surface (200_{S,U}) of the heat sink (200);
positioning a lower surface of the base plate (120) on the upper surface (200_{S,U}) of the heat sink (200) such that each of the at least two alignment features (270) is received by the aperture (137) in one of the at least two housing protrusions (135).

15. The method of claim 13, further comprising attaching a proximal end of each of a plurality of pins (110) to the substrate (140) such that each of the pins (110) extends upwardly beyond an upper surface of the housing (130).
